# FASCICULE DE BREVET EUROPEEN

(11) **EP 2 110 887 B1**
(45) Date de publication et mention de la délivrance du brevet: **22.02.2012**
(21) Numéro de dépôt: 09157240.4
(22) Date de dépôt: 03.04.2009
(51) Int. Cl.: H01R 4/68

(54) **Agencement de connexion de deux câbles supraconducteurs**
Verbindungsanordnung von zwei Supraleitungskabeln
Arrangement for connecting two superconducting cables

(30) Priorité: 16.04.2008 FR 0852541
(43) Date de publication de la demande: 21.10.2009
(73) Titulaire: Nexans, 75008 Paris (FR)
(72) Inventeur: Lallouet, Nicolas, 62132 Fiennes (FR)
(74) Mandataire: Lenne, Laurence

(56) Documents cités:
- EP-A- 1 804 337
- EP-A- 1 830 445
- FR-A- 2 878 654
- GB-A- 2 350 495
- GB-A9- 2 331 868

## Description

L'invention concerne un agencement de connexion de deux câbles supraconducteurs.

Le transport du courant électrique à l'aide de câbles supraconducteurs haute tension permet de transporter des courants électriques de forte intensité avec des sections de câbles beaucoup plus faibles que celle de câbles classiques composés de conducteurs électriques résistifs, tout en limitant les pertes électriques le long du câble, notamment les pertes par effet Joule puisque ce phénomène est extrêmement faible en supraconductivité.

Un câble supraconducteur dit « à diélectrique froid » est constitué d'un supraconducteur électrique central constitué au moins d'une partie supraconductrice, d'une couche diélectrique entourant ledit supraconducteur central, d'un écran entourant ladite couche diélectrique et pouvant être constitué pour tout ou partie de supraconducteurs et d'une enceinte cryogénique ou cryostat entourant ledit écran. Ledit cryostat est constitué généralement de deux enveloppes concentriques isolées thermiquement entre elles, par un niveau de vide de 10⁻⁵ mbar par exemple. Un fluide cryogénique contenu à l'intérieur de l'enveloppe interne du cryostat refroidit le conducteur central à travers la couche diélectrique, d'où la désignation de "diélectrique froid", jusqu'à atteindre la température pour laquelle le conducteur central est dans un état de supraconductivité. Cette température est par exemple de l'ordre de - 196°C pour des supraconducteurs dit « haute température ».

Dans le cas des câbles supraconducteurs à diélectrique froid, des courants d'intensité similaire sont amenés à circuler dans l'écran, notamment si cet écran est constitué pour tout ou partie de supraconducteur, et dans le conducteur central. Pour les câbles à haute tension, la valeur de ce courant peut être élevée, par exemple 2400 Ampères.

C'est également le cas des câbles supraconducteurs, dits à « diélectrique chaud », où le conducteur est constitué d'un élément creux en général un tube, dans lequel circule un fluide cryogénique.

Une solution pour connecter deux tels câbles supraconducteurs, est d'utiliser un agencement tel que décrit dans le document de brevet FR 2 878 654.

Ce document décrit un agencement de connexion des écrans de câbles supraconducteurs comportant un câble supraconducteur de liaison entre les écrans, ce câble de liaison comportant un supraconducteur de liaison et une gaine cryogénique entourant le supraconducteur de liaison, chacune des deux extrémités du supraconducteur de liaison étant reliée à l'un des écrans par des moyens de connexion électriquement et thermiquement conducteurs.

Cependant, un tel agencement est particulièrement complexe et coûteux, car il nécessite une entrée et une sortie supplémentaire de fluide cryogénique et un supraconducteur de liaison spécifique.

Pour résoudre ces problèmes, l'invention concerne un agencement de deux tels câbles supraconducteurs, en particulier aboutés l'un à l'autre, de conception simple et ne nécessitant pas de circuit de fluide cryogénique supplémentaire.

Pour ce faire, l'invention propose un agencement de connexion de deux câbles supraconducteurs, comportant un conducteur central constitué au moins d'une partie supraconductrice, d'une couche diélectrique entourant ledit conducteur central, d'un écran entourant ladite couche diélectrique et d'une enceinte cryogénique entourant ledit écran, agencement comportant un dispositif de raccordement électrique des dits conducteurs centraux et des dites couches diélectriques dénudés du dit écran correspondant et caractérisé en ce qu'il comporte un revêtement de matériau semi conducteur disposé entre les deux extrémité d'écrans et un dispositif de connexion électrique de ces dites deux extrémités d'écran, entourant ledit revêtement et contenu dans ladite enceinte cryogénique et comportant deux éléments de jonction (5, 5') reliés électriquement et mécaniquement respectivement à chacune des dites extrémités d'écran et un agencement de raccordement électrique (7) de ces deux éléments de jonction.

Le revêtement semi conducteur assure le confinement du champ électrique dans la couche diélectrique et le dispositif de connexion électrique permet la transmission du courant transmis par les écrans.

Selon un mode de réalisation préféré, ledit agencement de raccordement électrique est constitué d'une pluralité de tresses conductrices connectées par leurs extrémités aux dits élément de jonction et réparties autour du dit revêtement semi conducteur.

Lesdites tresses peuvent être en cuivre.

Cette connexion par tresses est particulièrement aisé à mettre en place, de par la flexibilité des ces tresses. Elle est également particulièrement peu coûteuse. Elle assure également la possibilité de déformation, de type contraction thermique, due à la température du fluide cryogénique.

Avantageusement, chaque dit élément de jonction est formé par un tube dont la paroi interne est fixée à la paroi externe dudit écran.

De préférence, ledit tube est pourvu d'une bride annulaire destinée à la fixation de cosses d'extrémité des dites tresses.

Chaque dit élément de jonction est avantageusement fixé par brasure ou soudure à l'aide d'un alliage à basse température de fusion, à l'extrémité d'écran correspondante.

Lesdits éléments de jonction peuvent être en cuivre.

Ledit revêtement de matériau semi conducteur peut être un enroulement de ruban de papier à noir de carbone.
La figure 1 est une vue en coupe longitudinale de deux câbles supraconducteurs en cours de connexion, selon une première étape.
La figure 2 est une vue en coupe longitudinale de deux câbles supraconducteurs en cours de connexion, selon une seconde étape.
La figure 3 est une vue en coupe longitudinale d'un agencement de connexion de deux câbles supraconducteurs, conforme à l'invention.
Les figures 4 et 5 sont des vues en perspective de détail.

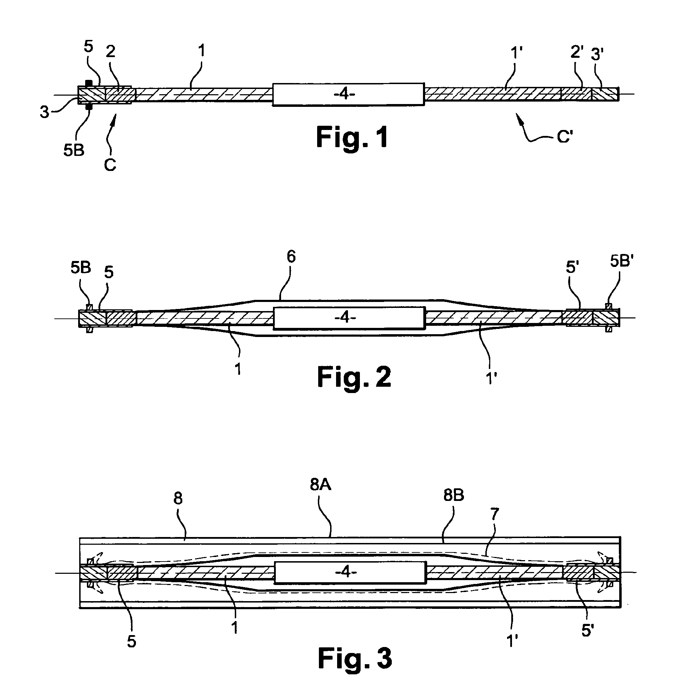

Comme illustré sur la figure 1, l'extrémité de chaque câble supraconducteur à diélectrique froid, C, C', destiné à être connecté l'un à l'autre de façon aboutée, est tout d'abord libérée de l'écran pour laisser apparaître la couche diélectrique 1, 1', qui entoure le conducteur central de chaque câble. Cette couche diélectrique est par exemple constituée de plusieurs couches de papier à base de polypropylène (PPLP).

L'écran est ici formé d'une couche de matériau supraconducteur 2, 2' et d'un écran métallique, de préférence en cuivre, 3, 3', ce dernier étant coupé de façon à laisser libérée une petite longueur de cette couche de matériau supraconducteur 2, 2'.

L'agencement de connexion comporte tout d'abord un dispositif de raccordement électrique 4 des conducteurs centraux et des couches diélectriques, dénudés de l'écran correspondant. Ce dispositif de raccordement est en soi connu et peut être du type de celui décrit dans le document de brevet EP 1 195 872.

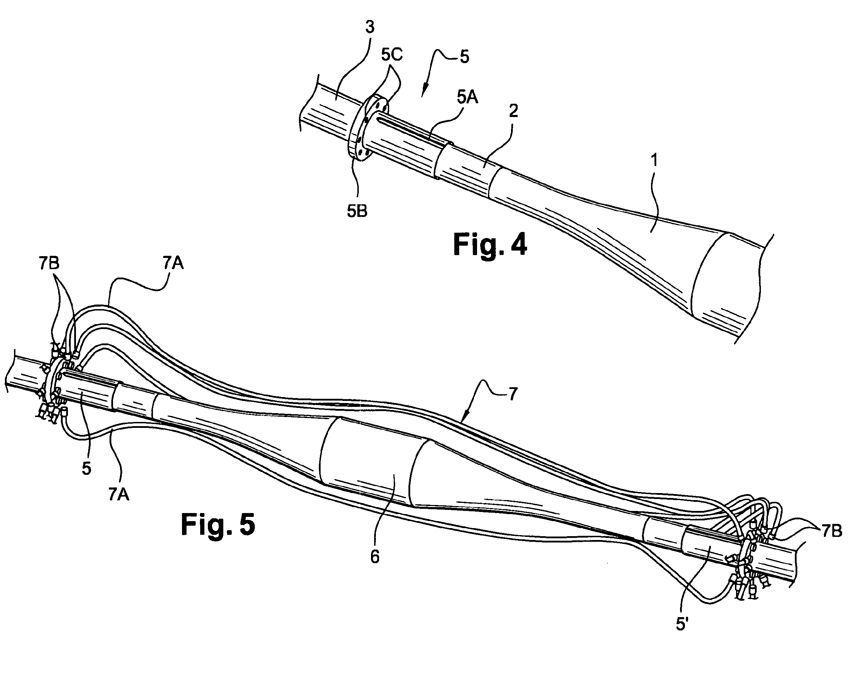

Sur le câble de gauche C, un élément de jonction 5 est relié électriquement et mécaniquement à l'extrémité de l'écran, de façon à chevaucher la couche supraconductrice 2 et l'écran métallique 3 et à en être relié. Cet élément de jonction 5 est particulièrement visible sur la figure 4. Il est formé par un tube, en un matériau bon conducteur électrique, de préférence en cuivre, dont la paroi interne est fixée à la paroi externe de l'écran, à savoir la couche de matériau supraconducteur 2 et l'écran métallique 3, ce tube étant disposé de façon à chevaucher ces deux parties.

Pour ce faire, l'élément de jonction 5 est fixé par brasure ou soudure à l'aide d'un alliage à basse température de fusion, introduit dans une fente longitudinale 5A agencé dans le tube. Cet alliage assure de ne pas endommager la couche de matériau supraconducteur 2.

Le tube est pourvu d'une bride annulaire 5B destinée à la fixation de cosses, comme il sera vu plus loin, et pourvue pour ce faire d'orifices 5C régulièrement répartis angulairement autour du tube 5.

L'agencement de connexion conforme à l'invention comporte un revêtement de matériau semi conducteur disposé entre les deux extrémités d'écrans et un dispositif de connexion électrique de ces deux extrémités d'écran, entourant ce revêtement et contenu dans l'enceinte cryogénique contenant les câbles C, C', comme il est vu maintenant en référence aux figures 2 et 3.

Comme illustré sur la figure 2, chaque extrémité d'écran est pourvue d'un élément de jonction 5, 5', électriquement et mécaniquement relié respectivement à chacune des extrémités d'écran, tel que précédemment décrit, et un revêtement de matériau semi conducteur 6 est disposé entre les edeux éléments de jonction 5, 5' sur la longueur de la connexion, en formant des cônes d'extrémité de transition entre les différents diamètres, de façon classique. Ce revêtement de matériau semi conducteur 6 est de préférence un enroulement de ruban de papier à noir de carbone, qui peut être renforcé d'une fine toile de cuivre.

Ce revêtement semi conducteur 6 assure le confinement du champ électrique dans la couche diélectrique 1, 1'. A cette étape de l'élaboration de l'agencement de connexion, ce dernier assure le maintien de la tension mais ne permet pas la transmission du courant transmis par les écrans 2, 2', 3, 3'.

Ensuite, comme illustré sur la figure 3, un agencement de raccordement électrique 7 des deux éléments de jonction 5, 5' est mis en place autour du revêtement semi conducteur 6. Cet agencement de raccordement électrique 7 est particulièrement visible sur la figure 5 et est constitué d'une pluralité de tresses conductrices calibrées 7A, en un matériau bon conducteur électrique, de préférence en cuivre, connectées par leurs extrémités aux éléments de jonction 5, 5' et réparties autour du revêtement semi conducteur 6. Le diamètre de ces tresses 7A est calculé selon le courant à transmettre, sachant que leur résistance est faible, puisqu'elles sont ensuite immergées dans un liquide cryogénique.

Sur cette figure 5, toutes les tresses 7A ne sont pas représentées dans un but de visibilité, mais elles sont ici au nombre de huit et pourvues à leurs extrémités de cosses 7B connectées dans les orifices 5C prévus sur la bride 5B de chaque élément de jonction.

Une enceinte cryogénique ou cryostat 8 constituée d'une paroi externe 8A et d'une paroi interne 8B, entoure l'agencement de connexion. Un fluide cryogénique, de l'azote liquide par exemple, peut circuler à l'intérieur de la paroi interne 8B, afin de refroidir les câbles supraconducteurs C, C' et la connexion. Une isolation thermique est assurée entre la paroi interne 8B et externe 8A, par exemple un vide de 10⁻⁵ mbar, afin d'éviter un échauffement et une consommation importante du fluide cryogénique.

L'invention s'applique également à la connexion de deux câbles supraconducteurs à diélectrique chaud, la différence étant la constitution des conducteurs, tubulaires dans ce dernier cas.

## Revendications

1. Agencement de connexion de deux câbles supraconducteurs (C, C'), comportant un conducteur central constitué au moins d'une partie supraconductrice, d'une couche diélectrique (1, 1') entourant ledit conducteur central, d'un écran (2, 2', 3, 3') entourant ladite couche diélectrique et d'une enceinte cryogénique (8) entourant ledit écran, agencement comportant un dispositif de raccordement électrique (4) des dits conducteurs centraux et des dites couches diélectriques dénudés du dit écran correspondant et **caractérisé en ce qu'**il comporte un revêtement de matériau semi conducteur (6) disposé entre les deux extrémités d'écrans et un dispositif de connexion électrique de ces dites deux extrémités d'écran, entourant ledit revêtement, contenu dans ladite enceinte cryogénique et comportant deux éléments de jonction (5, 5') reliés électriquement et mécaniquement respectivement à chacune des dites extrémités d'écran et un agencement de raccordement électrique (7) de ces deux éléments de jonction.

2. Agencement selon la revendication précédente, **caractérisé en ce que** ledit agencement de raccordement électrique (7) est constitué d'une pluralité de tresses conductrices (7A) connectées par leurs extrémités aux dits élément de jonction (5, 5') et réparties autour du dit revêtement semi conducteur (6).

3. Agencement selon la revendication précédente, **caractérisé en ce que** lesdites tresses (7A) sont en cuivre.

4. Agencement de connexion selon l'une des revendications 1 à 3, **caractérisé en ce que** chaque dit élément de jonction (5, 5') est formé par un tube dont la paroi interne est fixée à la paroi externe dudit écran.

5. Agencement selon les revendications 2 et 4, **caractérisé en ce que** ledit tube est pourvu d'une bride annulaire (5B, 5B') destinée à la fixation de cosses d'extrémité des dites tresses.

6. Agencement de connexion selon l'une des revendications précédentes, **caractérisé en ce que** chaque dit élément de jonction (5, 5') est fixé par brasure ou soudure à l'aide d'un alliage à basse température de fusion, à l'extrémité d'écran correspondante.

7. Agencement selon l'une des revendications précédentes, **caractérisé en ce que** lesdits éléments de jonction (5, 5') sont en cuivre.

8. Agencement de connexion selon l'une des revendications précédentes, **caractérisé en ce que** ledit revêtement de matériau semi conducteur (6) est un enroulement de ruban de papier à noir de carbone.

## Claims

1. An arrangement for connecting two supraconducting cables (C, C), comprising a central conductor made up of at least one supraconducting part, a dielectric layer (1, 1') surrounding said central conductor, a screen (2, 2', 3, 3') surrounding said dielectric layer and a cryogenic enclosure (8) surrounding said screen, the arrangement comprising an electrical connecting device (4) of said central conductors and said stripped dielectric layers of said corresponding screen and **characterized in that** it comprises a coating of semiconducting material (6) positioned between the two screen ends and an electrical connection device of said two screen ends, surrounding said coating, contained in said cryogenic enclosure and comprising two junction elements (5, 5') electrically and mechanically connected, respectively, to said screen ends and an electrical connecting arrangement (7) of said two junction elements.

2. The arrangement according to the preceding claims, **characterized in that** said electrical connecting arrangement (7) is made up of a plurality of conducting braids (7A) connected by their ends to said junction elements (5, 5') and distributed around said semiconducting coating (6).

3. The arrangement according to the preceding claim, **characterized in that** said braids (7A) are made from copper.

4. The connection arrangement according to one of claims 1 to 3, **characterized in that** each said junction element (5, 5') is formed by a tube whereof the inner wall is secured to the outer wall of said screen.

5. The arrangement according to claims 2 and 4, **characterized in that** said tube is provided with an annular flange (5B, 5B') intended to fasten end lugs of said braids.

6. The connection arrangement according to one of the preceding claims, **characterized in that** said junction element (5, 5') is fixed by brazing or welding using an alloy with a low melting temperature, to the corresponding screen end.

7. The arrangement according to one of the preceding claims, **characterized in that** said junction elements (5, 5') are made from copper.

8. The connection arrangement according to one of the preceding claims, **characterized in that** said semiconducting coating (6) is a carbon black paper strip winding.

## Patentansprüche

1. Verbindungsanordnung zweier supraleitender Kabel (C, C'), die einen zentralen Leiter aufweist, der aus mindestens einem supraleitenden Teil, einer dielektrischen Schicht (1, 1'), die den zentralen Leiter umschließt, einer Abschirmung (2, 2', 3, 3'), die die dielektrische Schicht umschließt, und einem Kryoraum (8), der die Abschirmung umschließt, besteht, wobei die Anordnung eine elektrische Anschlussvorrichtung (4) der zentralen Leiter und der von der entsprechenden Abschirmung befreiten dielektrischen Schichten aufweist und **dadurch gekennzeichnet ist, dass** sie eine Umhüllung aus halbleitendem Werkstoff (6) aufweist, die zwischen den zwei Abschirmungsenden angeordnet ist und eine elektrische Verbindungsvorrichtung dieser zwei Abschirmungsenden, die die Umhüllung umschließt, die in dem Kryoraum enthalten ist und zwei Kupplungselemente (5, 5') aufweist, die elektrisch und mechanisch jeweils mit jedem der Abschirmungsenden verbunden sind und eine elektrische Anschlussanordnung (7) dieser zwei Kupplungselemente.

2. Anordnung nach vorangehendem Anspruch, **dadurch gekennzeichnet, dass** die elektrische Anschlussanordnung (7) aus einer Vielzahl leitender Beflechtungen (7A) besteht, die mit ihren Enden mit den Kupplungselementen (5, 5') verbunden sind und um die halbleitende Umhüllung (6) verteilt sind.

3. Anordnung nach vorangehendem Anspruch, **dadurch gekennzeichnet, dass** die Beflechtungen (7A) aus Kupfer sind.

4. Verbindungsanordnung nach einem der Ansprüche 1 bis 3, **dadurch gekennzeichnet, dass** jedes Kupplungselemente (5, 5') von einem Rohr gebildet wird, dessen Innenwand an der Außenwand der Abschirmung befestigt ist.

5. Anordnung nach den Ansprüchen 2 und 4, **dadurch gekennzeichnet, dass** das Rohr mit einem Ringflansch (5B, 5B') ausgestattet ist, der zur Befestigung von Kabelendschuhen der Beflechtungen bestimmt ist.

6. Verbindungsanordnung nach einem der vorangehenden Ansprüche, **dadurch gekennzeichnet, dass** jedes Kupplungselement (5, 5') durch Löten oder Schweißen mit Hilfe einer Legierung mit niedriger Schmelztemperatur am Ende der entsprechenden Abschirmung befestigt ist.

7. Anordnung nach einem der vorangehenden Ansprüche, **dadurch gekennzeichnet, dass** die Kupplungselemente (5, 5') aus Kupfer sind.

8. Verbindungsanordnung nach einem der vorangehenden Ansprüche, **dadurch gekennzeichnet, dass** die Umhüllung aus halbleitendem Werkstoff (6) eine Umwicklung aus einem rußschwarzen Papierstreifen ist.
